Europäisches Patentamt

European Patent Office

Office européen des brevets

(19)

(11) Veröffentlichungsnummer: **0 000 909**
**B1**

(12) **EUROPÄISCHE PATENTSCHRIFT**

(45) Veröffentlichungstag der Patentschrift: **22.07.81**

(51) Int. Cl.³: **H 01 L 29/72, H 01 L 27/08**

(21) Anmeldenummer: **78100655.6**

(22) Anmeldetag: **16.08.78**

(54) Lateraler Transistor.

(30) Priorität: **31.08.77 US 830222**

(43) Veröffentlichungstag der Anmeldung:
**07.03.79 Patentblatt 79/5**

(45) Bekanntmachung des Hinweises auf die Patenterteilung:
**22.07.81 Patentblatt 81/29**

(84) Benannte Vertragsstaaten:
**DE FR GB**

(56) Entgegenhaltungen:
**FR - A - 2 337 433**

**BULLETIN SEV/VSE, Vol. 68, Nr. 2 22. Januar
1977, Zürich
J. LOHSTROH: "Integrated injection logic",
Seiten 53—59**

**IEEE J. OF SOLID-STATE CIRCUITS, Vol. SC—12,
Nr. 2, April 1977, New York,
Y. TOKUMARU et al. "I²L with a self-aligned
double diffused injector", Seiten 109—114**

(73) Patentinhaber: **International Business Machines
Corporation
Armonk, N.Y. 10504 (US)**

(72) Erfinder: **Gates, Harlan Rogene
11305 Handlebar Road
Reston Virginia 22091 (US)**

(74) Vertreter: **Gaugel, Heinz, Dipl.-Ing.
Schönaicher Strasse 220
D-7030 Böblingen (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

## Lateraler Transistor

Die Erfindung betrifft einen lateralen Transistor gemäß dem ersten Teil des Anspruchs 1, der sich insbesondere zusammen mit komplementären vertikalen Transistoren integriert herstellen läßt.

Laterale Transistoren in Verbindung mit komplementären vertikalen Transistoren werden beispielsweise in den bekannten I²L-Strukturen (Integrated Injection Logic) verwendet.

Beispielsweise ist in der Veröffentlichung "IEEE Solid State Conference", 1976, von Y. Tokumaru, et al., unter dem Titel "I²L with Self-Aligned Double Diffused Injector" auf den Seiten 100 und 101 eine Struktur mit einem lateralen PNP-Transistor und einem vertikalen NPN-Transistor beschrieben, die in einer P-dotierten Epitaxieschicht gebildet sind. Die Basiszone des NPN-Transistors wird dabei durch die Epitaxieschicht selbst gebildet. Hierbei handelt es sich um eine typische, kostengünstige, keine optimale Eigenschaften aufweisende bipolare Struktur, bei der sich die relativ großen Toleranzen in der Dicke der Epitaxieschicht und damit die großen Schwankungen in den Eigenschaften des vertikalen NPN-Transistors ungünstig auswirken.

Aus der FR—A—2 337 433 ist es über den ersten Teil des Anspruchs 1 hinaus bekannt, daß bei einem lateralen Transistor ein zu ihm komplimentärer, vertikaler Transistor mitintegriert ist, wobei die Kollektorzone des lateralen Transistors der Basiszone des vertikalen Transistors in Lage und Leitungstyp entspricht, und bei dem in die Basiszone des vertikalen Transistors dessen Emitterzone eingebracht ist.

Auch hier wirken sich die Toleranzen in der Dicke der Epitaxieschicht auf die Eigenschaften sowohl des vertikalen als auch des lateralen Transistors ungünstig aus, da die Basiszone des vertikalen Transistors durch die Epitaxieschicht selbst gebildet wird und die intrinsische Basiszone des lateralen Transistors durch die ebenfalls die gesamte Dicke der Epitaxieschicht umfassende Kollektorzone bestimmt wird.

Hier will die Erfindung Abhilfe schaffen. Die Erfindung, wie sie in den Ansprüchen gekennzeichnet ist, löst die Aufgabe, einen lateralen Transistor anzugeben, der bei kleinstem Flächenbedarf und optimalen Eigenschaften gleichzeitig mit komplementären, vertikalen Transistoren herstellbar ist, wobei die Basiszone, die Kollektorzone und die Emitterzone des lateralen Transistors in dieser Reihenfolge mit der Kollektorkontaktierungszone, der Basiszone und der Basisanschlußzone des vertikalen Transistors kompatibel sind und insbesondere eine definierte Basisweite des lateralen Transistors erzielbar ist.

Zusammenfassend kann die Erfindung im wesentlichen darin gesehen werden, daß die Epitaxieschicht den ersten Leitungstyp aufweist, daß die Kollektorzone in der Oberfläche der Epitaxieschicht von der Subbasiszone beabstandet angeordnet ist und daß sich die Basiszone durch die sie teilweise umgebende Kollektorzone und die Epitaxieschicht hindurch bis in die Subbasiszone erstreckt, so daß die aktive intrinsische Basiszone durch die Seitenflächen der Emitterzone und der Kollektorzone (44) definiert ist. Besondere Ausführungsarten der Erfindung sind in den Unteransprüchen gekennzeichnet.

Die Subbasiszone dient dem niederohmigen elektrischen Anschluß der Basiszone, wobei die Epitaxieschicht als extrinsische Basiszone anzusehen ist, über die der Anschluß der aktiven intrinsischen Basiszone zur Oberfläche erfolgt. In die Basiszone wird mit Hilfe desselben Maskenfensters die Emitterzone, vorzugsweise durch Implantation eingebracht. Diese doppeltdiffundierte Basis-Emitterstruktur ermöglicht die Einhaltung einer genauen Basisweite der intrinsischen Basis des lateralen Transistors. Auf diese Weise läßt sich ein optimale Eigenschaften aufweisender lateraler PNP-Transistor mit einem ebenfalls optimale Eigenschaften aufweisenden vertikalen NPN-Transistor in dem gleichen Halbleiterkörper integrieren, wobei das Merkmal der Selbstausrichtung der Zonen zueinander gewährleistet wird.

Im folgenden wird die Erfindung anhand von lediglich ein Ausführungsbeispiel darstellenden Zeichnungen näher erläutert.

Es zeigen die Fign. 1a bis 1i im wesentlichen Schnittansichten der Struktur des Ausführungsbeispiels in aufeinanderfolgenden Verfahrensschritten.

Hergestellt wird ein erfindungsgemäßer lateraler PNP-Transistor gleichzeitig mit einem vertikalen NPN-Transistor.

Wie in Fig. 1a dargestellt werden zunächst konventionelle Maskierungsprozesse, Dotierungsprozesse (Diffusion oder Ionenimplantation) und Beschichtungstechniken angewandt, um $N^+$-dotierte vergrabene Zonen 6 und 8 und $P^+$-dotierte vergrabene Zonen 10 in der Grenzschicht zwischen einem Substrat 2 und einer darauf aufgebrachten $N^-$-dotierten Epitaxieschicht 4 zu bilden. Auf die Epitaxieschicht ist zunächst eine Siliziumdioxidschicht 12 und darüber eine Siliziumnitridschicht 14 aufgebracht.

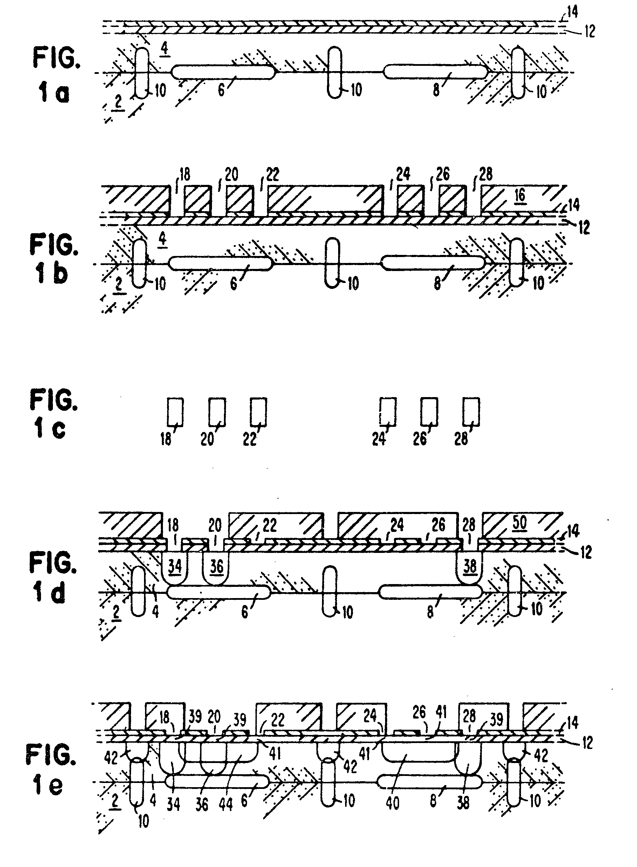

In Fig. 1b sind unter Verwendung einer Ätzmaske 16 aus Fotolack sämtliche Maskenfenster 18, 20, 22, 24, 26 und 28 in die Siliziumnitridschicht 14 geätzt. Die Draufsicht dieser Ätzmaske ist in Fig. 1c dargestellt.

Wie aus Fig. 1d zu ersehen, werden mit Hilfe einer Sperrmaske 50 aus Fotolack die Fenster definiert, in deren Bereich die Siliziumdioxidschicht 12 zu ätzen ist. In den dabei entstehenden Fenstern werden durch Implantation von beispielsweise Phosphor die N-leitenden Kontaktierungszonen 34 und 36 zu den N$^+$-dotierten vergrabenen Zonen 6 und 8 und die Basiszone 36 des lateralen Transistors gebildet. Dabei können gleichzeitig niederohmige N-dotierte Widerstände (75 Ohm/Flächeneinheit) gebildet werden. Die Implantation erfolgt mit niedriger Energie, so daß die durch die Siliziumdioxidschicht und die Siliziumnitridschicht definierten Maskenfenster 18, 20 und 28 die dabei erzeugten dotierten Zonen definieren. In einem nachfolgenden Reoxydationsprozeß werden im Bereich dieser Fenster 18, 20 und 28 Oxydschichten gebildet, die eine etwas geringere Dicke aufweisen als die ursprüngliche Siliziumdioxidschicht 12. Dabei diffundieren die N-dotierten Zonen 34, 36 und 38 weiter in die Epitaxieschicht 4 ein, so daß sie sich mit den ausdiffundierenden vergrabenen Zonen 6 und 8 treffen. Bei diesem Reoxydationsprozeß wird die Siliziumdioxydschicht 41 im Bereich der Fenster 22, 24 und 26 nur geringfügig verstärkt, so daß sich dort eine Bremswirkung für die Ionen ergibt, die der der Siliziumdioxidschicht 12 einschließlich der Siliziumnitridschicht 14 entspricht.

Aus Fig. 1e ist zu ersehen, wie unter Verwendung einer Sperrmaske aus Fotolack die Basiszone 40 des vertikalen NPN-Transistors, die Kollektorzone 44 des lateralen PNP-Transistors und die oberen Isolationszonen 42 eingebracht werden. Die Implantation von beispielsweise Bor erfolgt durch die Siliziumdioxidschichten 39, 41 bzw. 12 und die Siliziumnitridschicht 14. Es ist darauf hinzuweisen, daß die Zonen 40 und 44 ihre zugeordneten Anschlußfenster 24 und 22 nicht zu überlappen brauchen und daß ihre Überschneidung mit den Kontaktierungszonen 38 und 34 unkritisch ist, da die P-dotierten Zonen 40 und 44 durch die N-dotierten Zonen 38 und 34 kompensiert werden. Ist man bestrebt, geringe Kapazitäten zwischen diesen P- und N-dotierten Zonen 40, 38 und 44, 34 zu erzielen, so können sie in einem Abstand zueinander angeordnet werden, was zu einer leichten Erhöhung des Flächenbedarfs führt. Die P-dotierten Zonen 40 und 44 weisen einen hohen Schichtwiderstand (1000 Ohm/Flächeneinheit) auf, so daß sich eine niedrige Emitter-Basiskapazität für den vertikalen NPN-Transistor und eine hohe Kollektor-Basis-Durchbruchsspannung für den lateralen PNP-Transistor ergibt. Diese Zonen sind außerdem geeignet, Widerstände zu verwirklichen.

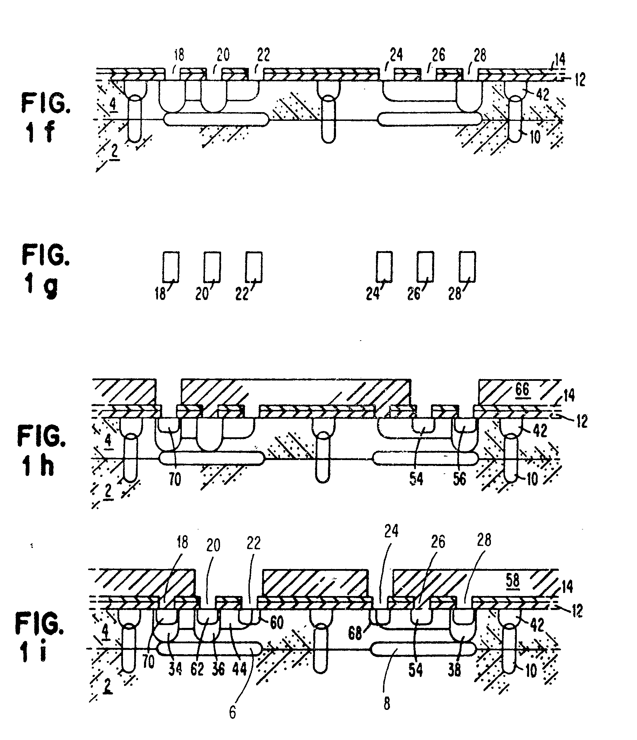

In Fig. 1f sind sämtliche Maskenfenster 18, 20, 22, 24, 26 und 28 durch die Siliziumdioxidschicht 39, 41 unter Verwendung der Siliziumnitridschicht 14 als Ätzmaske geätzt. Für diesen Ätzschritt ist keine gesonderte Maske erforderlich.

Fig. 1g zeigt die Draufsicht der durch die Siliziumnitridschicht 14 definierten Maskenfenster 18, 20, 22, 24, 26 und 28 in der Siliziumdioxydschicht.

In den beiden nächsten Prozeßschritten werden Sperrmasken aus Fotolack in Verbindung mit Ionenimplantationen verwendet. Die Reihenfolge der Prozeßschritte kann umgekehrt werden.

1. In Fig. 1h wird eine Sperrmaske 66 aus Fotolack verwendet, um die N$^+$-dotierte Emitterzone 54 des vertikalen NPN-Transistors, die Kollektoranschlußzone 56 des vertikalen Transistors und die Basisanschlußzone 70 des lateralen PNP-Transistors zu implantieren.

2. Fig. 1i zeigt die Verwendung einer Sperrmaske 58 aus Fotolack, mit deren Hilfe die P$^+$-dotierte Emitterzone 62 des lateralen PNP-Transistors, die Kollektoranschlußzone 60 des lateralen Transistors und die Basisanschlußzone 68 des vertikalen NPN-Transistors implantiert werden.

Im Anschluß an diese Ionenimplantationsprozesse wird ein Erwärmungsprozeß durchgeführt, bei dem die implantierten Bereiche aktiviert und die N$^+$- und P$^+$-dotierten Zonen bis zu ihrer endgültigen Tiefe ausdiffundiert werden.

## Patentansprüche

1. Lateraler Transistor, bei dem eine Epitaxieschicht (4) über einer hochdotierten vergrabenen Subbasiszone (6) eines ersten Leitungstyps angeordnet ist, bei dem über der Subbasiszone (6) eine Kollektorzone (44) des zweiten Leitungstyps angeordnet ist, bei dem in die Kollektorzone unter Verwendung einer Maske eine Basiszone des ersten Leitungstyps eingebracht ist, die sich bis in die Subbasiszone (6) erstreckt, bei dem unter Verwendung derselben Maske in die Basiszone (36) eine Emitterzone (62) des zweiten Leitungstyps eingebracht ist und bei dem die Subbasiszone (6) über eine Basiskontaktierungszone (34) des ersten Leitungstyps seitlich bis zur Oberfläche der Epitaxieschicht (4) geführt ist, dadurch gekennzeichnet, daß die Epitaxieschicht (4) den ersten Leitungstyp aufweist, daß die Kollektorzone (44) in der Oberfläche der Epitaxieschicht (4) von der Subbasiszone (6) beabstandet angeordnet ist und daß sich die Basiszone (36) durch die sie teilweise umgebende Kollektorzone (44) und die Epitaxieschicht (4) hindurch bis in die Subbasiszone erstreckt, so daß die aktive intrinsische Basiszone durch die Seitenflächen der Emitterzone (62) und der Kollektorzone (44) definiert ist.

2. Lateraler Transistor nach Anspruch 1, dadurch gekennzeichnet, daß in die Kollektorzone (44) seitlich von der Basiszone (36) eine Kollektoranschlußzone (60) des zweiten Leitungstyps eingebracht ist.

3. Lateraler Transistor nach Anspruch 1 oder 2, dadurch gekennzeichnet, daß in die Basiskontaktierungszone (34) eine Basisanschlußzone des ersten Leitungstyps eingebracht ist.

4. Lateraler Transistor nach den Ansprüchen 1 bis 3, dadurch gekennzeichnet, daß ein zu ihm komplementärer, vertikaler Transistor mitintegriert ist, wobei folgende Bereiche in Lage und Leitungstyp einander entsprechen: die Subbasiszone (6) des lateralen Transistors der Subkollektorzone (8) des vertikalen Transistors, die Kollektorzone (44) des lateralen Transistors der Basiszone (40) des vertikalen Transistors, die Basiskontaktierungszone (34) des lateralen Transistors der Kollektorkontaktierungszone (38) des vertikalen Transistors und daß in die Basiszone (44) des vertikalen Transistors dessen Emitterzone (54) eingebracht ist.

5. Lateraler Transistor nach Anspruch 4, dadurch gekennzeichnet, daß die Basisanschlußzone (70) des lateralen Transistors gleichzeitig mit der Emitterzone (54) des vertikalen Transistors hergestellt ist.

6. Lateraler Transistor nach Anspruch 4 oder 5, dadurch gekennzeichnet, daß die Kollektoranschlußzone (60) des lateralen Transistors der Basisanschlußzone (68) des vertikalen Transistors in Lage und Leitungstyp entspricht.

**Revendications**

1. Transistor latéral dans lequel une couche épitaxique (4) est placée sur une région de sous-base (6) enterrée, fortement dopée, d'un premier type de conductivité, une région de collecteur (44) du second type de conductivité est placée sur la région de sous-base (6), une région de base du premier type de conductivité qui pénètre dans la région de sous-base (6) a été introduite au moyen d'un masque dans la région de collecteur, une région d'émetteur (62) du second type de conductivité a été introduite au moyen du même masque dans la région de base (36), et dans lequel la région de sous-base (6) s'étend latéralement jusqu'à la surface de la couche épitaxique (4) à travers une région de connexion à la base (34) du premier type de conductivité, caractérisé en ce que: la couche épitaxique (4) est du premier type de conductivité, la région de collecteur (44) se trouve dans la surface de la couche épitaxique (4), espacée de la région de sous-base (6), et la région de base (36) pénètre, à travers la région de collecteur (44) l'entourant partiellement, et à travers la couche épitaxique (4), jusque dans la région de sous-base de sorte que la région de base active, intrinsèque est définie par les côtés latéraux de la région d'émetteur (62) et la région de collecteur (44).

2. Transistor latéral selon la revendication 1, caractérisé en ce qu'une région de contact de collecteur (60) du second type de conductivité est placée dans la région de collecteur (44), latéralement par rapport à la région de base (36).

3. Transistor latéral selon l'une quelconque des revendications 1 ou 2, caractérisé en ce qu'une région de contact de base du premier type de conductivité est placée dans la région de connexion à la base (34).

4. Transistor latéral selon les revendications 1 à 3, caractérisé en ce qu'un transistor vertical, complémentaire à celui-ci, est intégré avec lui, les régions suivantes se correspondant quant à la position et au type de conductivité: la région de sous-base (6) du transistor latéral et la région de sous-collecteur (8) du transistor vertical, la région de collecteur (44) du transistor latéral et la région de base (40) du transistor vertical, la région de connexion à la base (34) du transistor latéral et la région de connexion au collecteur (38) du transistor vertical, et que la région d'émetteur (54) du transistor vertical est placée dans la région de base (44) de celui-ci.

5. Transistor latéral selon la revendication 4, caractérisé en ce que la région de contact de base (70) du transistor vertical est produite en même temps que la région d'émetteur (54) du transistor vertical.

6. Transistor latéral selon l'une quelconque des revendications 4 ou 5, caractérisé en ce que la région de contact de collecteur (60) du transistor latéral correspond, quant à la position et au type de conductivité, à la région de contact de base (68) du transistor vertical.

**Claims**

1. A lateral transistor structure comprising an epitaxial layer (4) arranged over a highly doped, buried sub-base region (6) of a first conductivity type; a collector region (44) of the second conductivity type arranged over the sub-base region (6); a base region (36) of the first conductivity type formed in the collector region by means of a mask and which extends to the sub-base region (6), an emitter region (62) of the second conductivity type introduced into the base region (36) using the same mask, and a base reach through contact region (34) of the first conductivity type connecting the sub-base region (6) to the surface of the epitaxial layer (4), characterised in that the epitaxial layer (4) is of the first conductivity type, in that the collector region (44) is formed in the surface of the epitaxial layer (4) and is spaced from the sub-base region (6), and in that the base region (36) extends through the collector region (44), which surrounds the part of the base region extending through it, and through the epitaxial layer (4) to the sub-base region (6) so that the active intrinsic base region is defined by the lateral sides of the emitter region (62) and the collector region (44).

2. A lateral transistor structure as claimed in claim 1, characterised in that a collector contact region (60) of the second conductivity type is provided in the collector region (44) spaced laterally from the base region (36).

3. A lateral transistor structure as claimed in claim 1 or 2, characterised in that a base contact region of the first conductivity type is provided in the base reachthrough contact region (34).

4. A lateral transistor structure as claimed in claims 1, 2 or 3, characterised in that during integration of the lateral transistor a vertical transistor complementary thereto is also integrated, the following regions corresponding to each other with respect to position and conductivity type: the sub-base region (6) of the lateral transistor to the sub-collector region (8) of the vertical transistor; the collector region (44) of the lateral transistor to the base region (40) of the vertical transistor; the base reachthrough contact region (34) of the lateral transistor to the collector reachthrough contact region (38) of the vertical transistor; and that in the base region (40) of the vertical transistor its emitter region (54) is provided.

5. A lateral transistor structure is claimed in claim 4, characterised in that the base contact region (70) of the lateral transistor is made simultaneously with the emitter region (54) of the vertical transistor.

6. A lateral transistor structure as claimed in claim 4 or 5, characterised in that the collector contact region (60) of the lateral transistor corresponds in position and conductivity type to the base contact region (68) of the vertical transistor.

FIG.
1 a

FIG.
1 b

FIG.
1 c

FIG.
1 d

FIG.
1 e

0 000 909

FIG. 1 f

FIG. 1 g

FIG. 1 h

FIG. 1 i